Europäisches Patentamt

European Patent Office

Office européen des brevets

(11) Veröffentlichungsnummer: **0 609 662 A1**

# (12) EUROPÄISCHE PATENTANMELDUNG

(21) Anmeldenummer: **94100228.9**

(22) Anmeldetag: **10.01.94**

(51) Int. Cl.5: **G01R 31/32**

(30) Priorität: **03.02.93 DE 4303018**

(43) Veröffentlichungstag der Anmeldung:
**10.08.94 Patentblatt 94/32**

(84) Benannte Vertragsstaaten:
**AT CH DK ES FR GB IT LI SE**

(71) Anmelder: **Klöckner-Moeller GmbH**
**Hein-Moeller-Strasse 7-11**
**D-53115 Bonn(DE)**

(72) Erfinder: **Zender, Christoph**
**Pallaswiesenstrasse 131**
**D-64293 Darmstadt(DE)**

(54) Verfahren zur Ermittlung der thermischen Festigkeit vonSchutzschaltern unter Berücksichtigung der Oberwellen der Phasenströme und Schaltungsanordnung zur Durchführung des Verfahrens.

(57) Mit der Erfindung wird das Problem gelöst, trotz des dem Grunde nach nicht vorhersagbaren Einflusses oberschwingungshaltiger Phasenströme auf das thermische Verhalten eines Schutzschalters eine sichere Aussage über dessen zulässigen Betriebsstrom innerhalb eines geforderten Temperaturbereiches zu treffen. Die Phasenströme werden in mehreren Verfahrensstufen derart verarbeitet, daß über die Umwandlung von physikalischen Teilgrößen, die der Grundfrequenz der Phasenströme entsprechen, letztendlich ein für die oberen Phasenklemmen maßgeblicher Strom ermittelt wird, der die thermisch äquivalente physikalische Größe für einen thermisch gleichwirkenden oberschwingungsfreien Phasenstrom der gleichen Grundfrequenz darstellt. Mit einem zusätzlichen Verfahrensschritt wird die maßgebliche Übertemperatur an der betreffenden oberen Phasenklemme ermittelt.

Fig. 2

EP 0 609 662 A1

Die Erfindung betrifft ein Verfahren gemäß dem Oberbegriff des Patentanspruches 1 sowie eine Schaltungsanordnung zur Durchführung des Verfahrens.

Die durch Schutzschalter fließenden Betriebs- bzw. Phasenströme sind nicht in jedem Falle sinusförmig und folglich oberschwingungshaltig. Dies wird insbesondere durch Sättigungseffekte von verbraucherseitigen Induktivitäten und durch den in jüngster Zeit verstärkten Einsatz von leistungselektronischen Bauelementen bzw. Geräten, beispielsweise getakteten Stromversorgungen, in Starkstromanlagen oder Maschinen hervorgerufen. Nach FOURIER ist eine nichtsinusförmige periodische Schwingung als ein Gemisch mehrerer oder unendlich vieler Sinusschwingungen aufzufassen, deren Frequenzen ganzzahlige Vielfache der Frequenz der Grundschwingung sind. Wegen der frequenzabhängigen Verluste in Schutzschaltern, insbesondere Hystereseverlusten in ferromagnetischen Baugruppen, Wirbelstromverlusten in Metallteilen und ohmschen Verlusten durch den Stromverdrängungs-Effekt, können oberschwingungshaltige Phasenströme eine größere Erwärmung und damit höhere Übertemperatur des Schutzschalters hervorrufen als rein sinusförmige Phasenströme gleichen Effektivwertes. Im allgemeinen ist der genaue Stromverlauf bzw. dessen spektrale Verteilung nicht vorherbestimmbar. Infolge der Unkenntnis des thermischen Verhaltens von Schutzschaltern bei oberschwingungshaltigen Phasenströmen ist es nicht möglich, eine optimierte Auswahl für den Schutzschalter nach dem zulässigen Betriebsstrom innerhalb des geforderten Temperaturbereiches zu treffen. Daher wird bei einem zu erwartenden, nicht unerheblichen Oberschwingungsanteil in vielen Fällen der nächstgrößere und damit teurere Schutzschalter eingesetzt, um Ausfälle bei ungünstigen Betriebsbedingungen, insbesondere bei höheren Umgebungstemperaturen, von vornherein auszuschließen.

Es ist an sich bekannt, die Temperaturerfassung mittels Thermosensoren vorzunehmen. Das hat jedoch die entscheidenden Nachteile, daß die Thermosensoren an geeigneten Stellen im oder am Schutzschalter zu plazieren sind, daß die Betriebs- und Umgebungsbedingungen über längere Zeit konstant zu halten sind, daß die erhaltenen Meßergebnisse ausschließlich für diese Betriebs- und Umgebungsbedingungen gelten und daß dadurch die Prüfung einen sehr hohen Zeitaufwand erfordert und bei geänderten Betriebs- oder Umgebungsbedingungen wiederholt werden muß.

Aus der DE-A 40 14 629 ist eine mehrpoliges Schutzrelais bekannt, welches mindestens ein auf thermische Einflüsse reagierendes Organ aufweist, welches der Heizwirkung von den Phasenströmen durchflossener temperaturunabhängiger Heizwiderstände ausgesetzt ist. Überschreitet der Strom, der von dem in Reihe mit dem Schutzrelais angeordneten Verbraucher aufgenommen wird, einen zulässigen Grenzwert, so wird durch die höhere Belastung der Heizwiderstände das temperaturabhängige Organ mit einer von der Belastung abhängigen Zeitverzögerung dahingehend verändert, daß das Schutzrelais zum Abschalten anspricht. Mit einem derartigen Schutzrelais läßt sich die Motor- bzw. Leitungstemperatur nachbilden. Es ist damit jedoch nicht möglich, für das Schutzrelais selbst das eigene thermische Verhalten infolge der durchfließenden Phasenströme nachzubilden, insbesondere dann, wenn diese Phasenströme mit einem nicht zu vernachlässigenden Oberwellenanteil behaftet sind.

In der DE-C 37 31 543 ist ein Verfahren und eine Anordnung zur Phasenausfallüberwachung bei einem Drehstromsystem beschrieben, bei dem über die erfaßten Phasenströme der Gesamteffektivwert der Ströme erfaßt wird. Über ein Bandfilter wird aus dem Frequenzspektrum des Gesamteffektivwertes ein Signalanteil mit denjenigen Frequenzen herausgefiltert, die bei einem Phasenausfall charakteristisch sind, wobei ein einen Schwellenwert übersteigender Wert des vom Bandfilter durchgelassenen Signalanteils über einen Fensterkomparator ein Phasenausfallsignal auslöst. Da durch die bandbegrenzte Auswertung des Gesamteffektivwert zum einen der Effektivwert bei Normalbetrieb unterdrückt wird und zum anderen die Oberwellenanteile im wesentlichen stark bedämpft werden, eignet sich dieses Verfahren nicht zur die Oberwellen berücksichtigenden Verarbeitung der Effektivwerte der Phasenströme. Die Auswirkungen der Oberwellenanteile auf einen mit der Anordnung zur Phasenausfallüberwachung ausgerüsteten Schutzschalter sind daher nicht erfaßbar.

Der Erfindung liegt daher die Aufgabe zugrunde, zur ausreichend sicheren Prüfung eines Schutzschalters auf seine thermische Festigkeit unter Berücksichtigung der Oberwellen von Phasenströmen (thermische Oberwellenfestigkeit) mit beliebigem und im Grunde unbekanntem Verlauf der Wechselströme in kurzer Zeit das thermische Verhalten des Schutzschalters charakterisierende physikalische Größen zu gewinnen.

Diese Aufgabe wird erfindungsgemäß durch ein Verfahren mit den kennzeichnenden Merkmalen des Patentanspruches 1 und durch die Schaltungsanordnung zur Durchführung des Verfahrens mit den Merkmalen des Patentanspruches 5 gelöst. Das Verfahren beruht auf der Erkenntnis, daß zur Bewertung des thermischen Verhaltens eines Schutzschalters in der Praxis für den Anwender die an den oberen Phasenklemmen im Klemmenraum des Schutzschalters sich einstellenden Temperaturen, die gegenüber der Umgebungstemperatur um den Betrag der Übertemperaturen erhöht sind, entscheidend sind. Die oberschwingungshaltigen Phasenströme durch den Schutzschalter werden in mehreren Verfahrensstufen derart verarbeitet, daß über die Umwandlung von physikalischen Teilgrößen, die der Grundfrequenz der Phasenströme entsprechen, letztendlich ein für die oberen Phasenklemmen maßgeblicher Strom ermittelt wird, der die thermisch äquivalente physikalische Größe für einen thermisch gleichwirkenden oberschwingungsfreien Phasenstrom der gleichen Grundfrequenz darstellt. Aus dem Vergleich des ermittelten maßgeblichen thermisch äquivalenten Stromes mit den technischen Daten des jeweiligen Schutzschalters, insbesondere mit dem maximalen Dauerstrom, erkennt der Anwender, ob der eingesetzte bzw. der einzusetzende Schutzschalter in thermischer Hinsicht in zulässiger Weise betrieben wird oder optimiert ist. Die für das Verfahren typspezifischen Parameter **a, b, m** und **k** sind zuvor in an sich bekannter Weise für den jeweiligen Schutzschaltertyp einmalig, i.a. durch den Hersteller, zu ermitteln. Dies erfolgt durch die Aufstellung von Meßreihen für die Klemmentemperatur mit einer Variation der Stromstärke und der Frequenz rein sinusförmiger, jeweils gleich großer Phasenströme, wobei die Auswertung der Meßreihen unter geeigneter Zugrundelegung der im Verfahrensschritt d) anzuwendenden Formel beispielsweise mit der Methode der kleinsten Fehlerquadrate vorgenommen werden kann. Der entscheidende Vorteil des vorgeschlagenen Verfahrens besteht darin, daß nicht nur ein thermischer Überlastschutz der zu schützenden Anlage sondern auch des Schutzschalters selbst realisiert wird, ohne daß eine aufwendige direkte Temperaturerfassung erforderlich ist. Der zulässige Temperaturbereich eines Schutzschalters ist für jeden beliebigen periodischen Strom im voraus, aber auch im nachhinein ermittelbar. Dies ist für den Projekteur bzw. Betreiber einer Anlage eine zuverlässige Aussage darüber, ob der Schutzschalter selbst bei ungünstigsten Betriebsbedingungen, insbesondere bei maximaler Umgebungstemperatur und erheblichem Oberschwingungsgehalt des Laststromes, thermisch überlastet wird oder nicht. Wenn der Projekteur einen bestimmten Temperaturbereich fordern muß, so lassen sich aus dem Verfahren Alternativvorschläge ableiten, wie etwa die Angabe des für den Schutzschalter maximal zulässigen Stromes unter Zugrundelegung des gleichen Stromverlaufes. Eine weitere vorteilhafte Nebenwirkung ist wegen der verfahrensgemäßen spektralen Stromerfassung eine Aussage über Fehlerquellen in der Anlage, z.B. Transformatorsättigung.

Vorteilhafte Ausgestaltungen sind den Unteransprüchen zu entnehmen. Mit einem zusätzlichen Verfahrensschritt ist die maßgebliche Übertemperatur an der betreffenden oberen Phasenklemme zu ermitteln. Es hat sich gezeigt, daß bei annähernd gleich großen Phasenströmen die maßgebliche, d.h. größte Übertemperatur an der mittleren oberen Phasenklemme bzw. eine der mittleren oberen Phasenklemmen auftritt. Auch bei unterschiedlich großen Phasenströmen stellt der ermittelte maßgebliche thermisch äquivalente Strom bzw. die ermittelte maßgebliche Übertemperatur mit ausreichender Sicherheit ein Prüfergebnis über die thermische Oberschwingungsfestigkeit des Schutzschalters dar. In der Praxis stellt die Berücksichtigung des Oberschwingungsgehaltes bis zum Zwanzigfachen der Grundfrequenz $f_1$ im Interesse der Verfahrensgeschwindigkeit und des erforderlichen Speicherplatzbedarfs eine sinnvolle Einschränkung dar, die noch zu hinreichend genauen Ergebnissen führt. Die Aussetzung des Verfahrens während des Auftretens von vereinzelten Lastspitzen, die den Charakter der Einmaligkeit über einen längeren Zeitraum tragen, ist zu empfehlen, da dies die Verfälschung der Verfahrensergebnisse, beispielsweise die Verfälschung durch das einmalige, relativ kurzzeitige Anlaufen einer Anlage, vermeidet. Beim Auftreten von Lastspitzen, die Wiederholungscharakter haben, werden diese durch eine Mittelwertbildung im richtigen Maße berücksichtigt.

Die in den weiteren Unteransprüchen aufgezeigten Schaltungsanordnungen geben vorteilhafte Ausführungen mit mikroelektronischen Mitteln zur Durchführung des Verfahrens an. Die wesentlichsten Bestandteile dieser Schaltungsanordnungen sind ein Mikrokontroller und ein diesem untergeordneter, i.a. schnellerer Signalprozessor. Der Mikrokontroller als Hostprozessor steuert die Meßwertverarbeitung nach den Verfahrensschritten a) und b) und bewältigt die Schnittstellenarbeit im allgemeinen. Die rechenintensiven Operationen der Verfahrensschritte c) bis g) bzw. h werden durch den für diese Zwecke geeigneten Signalprozessor als Coprozessor durchgeführt. Es ist von besonderem Vorteil, wenn für die Mittel zur Meßwertaufbereitung und -umwandlung, für den Mikrokontroller, die Datenübermittlungseinheit und die Stromversorgung bereits vorhandenen Bestandteile von digitalen Überstromauslösern der Schutzschalter verwendet werden. Damit sind die für die Durchführung des Verfahrens erforderlichen Mittel bereits zu einem erheblichen Teil im Schutzschalter vorhanden. Andererseits ist es von Vorteil, beispielsweise bei der Umrüstung einer älteren Anlage auf moderne Schutzschalter, wenn die Schaltungsanordnung zur Verfahrensdurchführung wesentlicher Bestandteil eines besonderen, tragbaren Prüfgerätes ist, mit dem die nach dem Verfahren zu prüfenden Schutzschalter vor Ort kontrolliert werden können. Die Ausbildung der Datenübermittlungseinheit als Schnittstelle zum externen Datenaustausch ermöglicht die Kommunikation mit einer zentralen Steuerung. Die Ausbildung der Datenübermittlungseinheit als oder mit Anzeige ermöglicht die direkte Ergebnisermittlung vor Ort. Die für das Verfahren schutzschaltertypischen Parameter können durch die entsprechende Einstellung von an sich bekannten Einstellmitteln, beispielsweise Kodierschaltern, oder über eine zentrale Steuerung zur Verfügung gestellt werden; sie können aber auch in dem Falle, wo die Schaltungsanordnung Bestandteil der Schutzschalter ist, programmiert werden.

Die Erfindung soll nachstehend anhand eines Ausführungsbeispieles, dem weitere vorteilhafte Merkmale und Wirkungen zu entnehmen sind, näher erläutert werden. In der zugehörigen Zeichnung zeigt

Fig. 1: eine schematische Darstellung des erfindungsgemäßen Verfahrensablaufes, aufgeteilt in zwei Teilfiguren Fig. 1a und Fig. 1b;

Fig. 2: eine erfindungsgemäße Schaltungsanordnung zur Durchführung des Verfahrens nach Fig. 1;

Fig. 3: einen detaillierten Ausschnitt der Schaltungsanordnung nach Fig. 2.

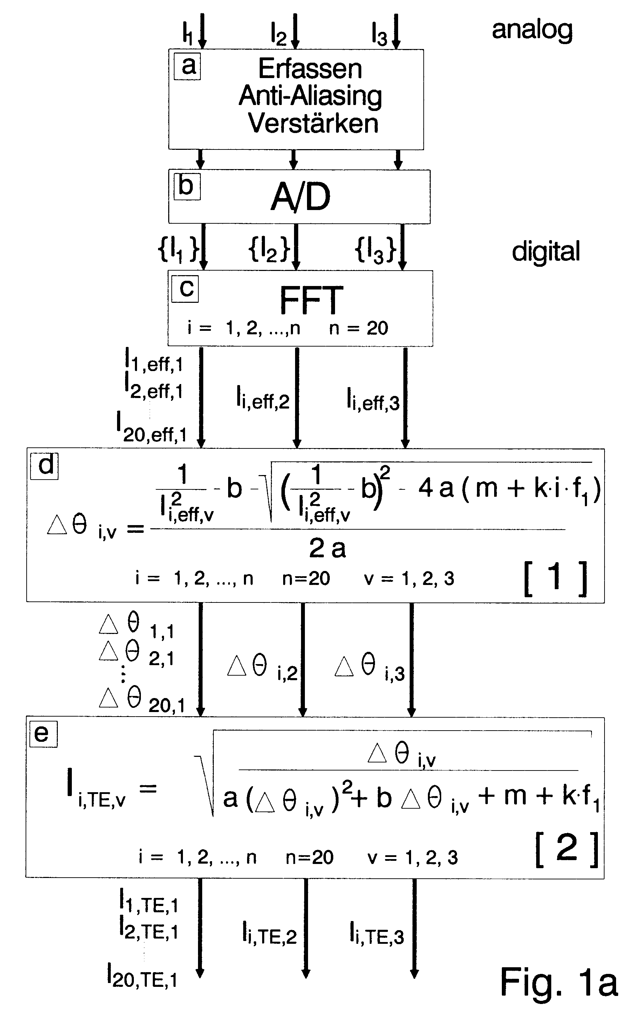

Die i.a. oberschwingungshaltigen Phasenströme $I_v$ ($v$ = 1, 2 und 3) mit der Grundfrequenz $f_1$ werden nach Fig. 1a in einem ersten Verfahrensschritt a) analog erfaßt, mittels Anti-Aliasing-Filter vorgefiltert und geeignet verstärkt. Die verstärkten Signale werden in einem zweiten Verfahrensschritt b) durch eine Analog-Digital-Umwandlung in zeit- und wertediskrete digitale Signalfolgen $\{I_v\}$ umgewandelt. Mittels der Anti-Aliasing-Filterung werden spektrale Verfälschungen, die bei der A/D-Umwandlung infolge der endlichen Abtastfrequenz auftreten, minimiert. Die digitalen Signalfolgen $\{I_v\}$ werden in einem dritten Verfahrensschritt c) mit Hilfe der Schnellen Fourier-Transformation dergestalt verarbeitet, daß die spektralen Teileffektivströme $I_{i,eff,v}$, welche die rein sinusförmigen Grund- und Oberschwingungen der Phasenströme $I_v$ repräsentieren, erhalten werden. Die Teilschwingung mit der Grundfrequenz $f_1$ (Grundschwingung) bzw. der doppelten Frequenz $2f_1$ (1. Oberschwingung) bzw. der dreifachen Frequenz $3f_1$ (2. Oberschwingung) usw. bzw. der zwanzigfachen Frequenz $20f_1$ (19. Oberschwingung) wird durch den Index $i$ = 1 bzw. 2 bzw. 3 usw. bzw. 20 gekennzeichnet. In einem vierten Verfahrensschritt d) werden durch digitale Verarbeitung der Teileffektivströme $I_{i,eff,v}$ unter Anwendung der Formel [1] für den jeweiligen Schutzschaltertyp anteilige Übertemperaturen $\Delta\theta_{i,v}$ an der betreffenden oberen Phasenklemme des Schutzschalters ermittelt. Jede anteilige Übertemperatur $\Delta\theta_{i,v}$ wird allein durch den entsprechenden Teileffektivstrom $I_{i,eff,v}$ der Oberschwingung mit der $i$-fachen Frequenz $i \cdot f_1$ in der Phase $v$ hervorgerufen. Da die Wirkung der Teileffektivströme $I_{i,eff,v}$ auf die anteiligen Übertemperaturen $\Delta\theta_{i,v}$ vom Schutzschaltertyp abhängt, werden in diesem und in dem darauffolgenden fünften Verfahrensschritt e) Konstanten **a**, **b**, **m** und **k** verwendet, die durch vorhergehende Auswertung geeigneter Meßreihen für den betreffenden Schutzschaltertyp als typspezifische Parameter einmalig ermittelt worden sind. Im fünften Verfahrensschritt e) werden die Teileffektivströme $I_{i,eff,v}$ mit Berücksichtigung der zugehörigen anteiligen Übertemperaturen $\Delta\theta_{i,v}$ unter Anwendung der Formel [2] digital in thermisch äquivalente Teilströme $I_{i,TE,v}$ umgewandelt. Jeder thermisch äquivalente Teilstrom $I_{i,TE,v}$ stellt den Effektivwert eines rein sinusförmigen Teilstromes mit der Grundfrequenz $f_1$ dar und ruft an der zugehörigen Phasenklemme des Schutzschalters die gleiche thermische Wirkung, d.h. die gleiche anteilige Übertemperatur $\Delta\theta_{i,v}$, wie der entsprechende Teileffektivstrom $I_{i,eff,v}$ mit der $i$-fachen Frequenz $i \cdot f_1$ hervor.

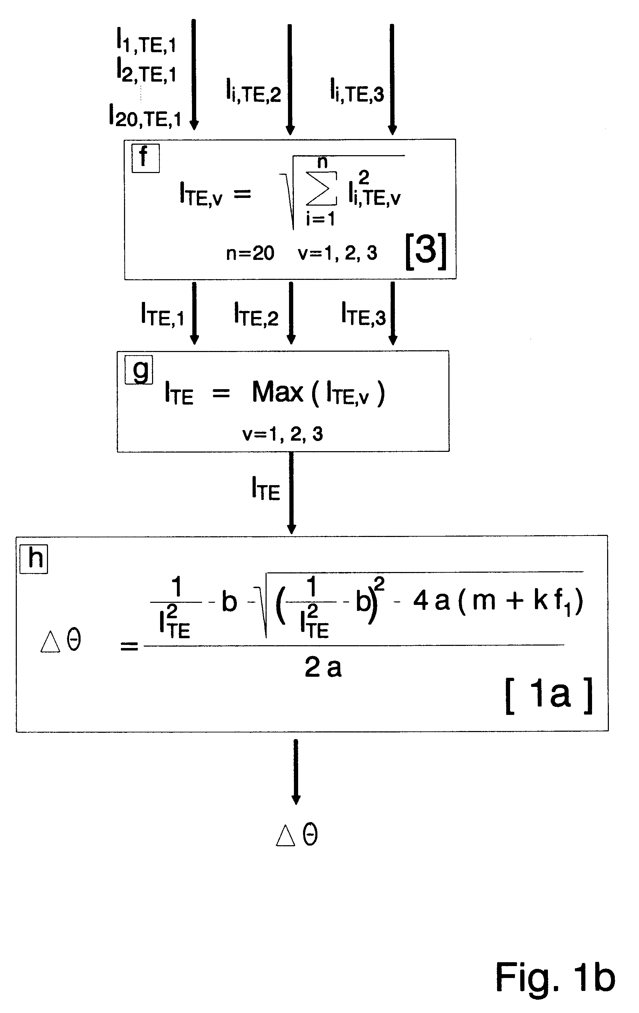

In dem nachfolgenden sechsten Verfahrensschritt f) wird nach Fig. 1b für die Gesamtheit der zu jeder betreffenden Phase $v$ gehörenden thermisch äquivalenten Teilströme $I_{i,TE,v}$ durch digitale quadratische Mittelwertbildung unter Anwendung der Formel [3] ein thermisch äquivalenter Phasenstrom $I_{TE,v}$ erfaßt. Die thermisch äquivalenten Phasenströme $I_{TE,v}$ stellen die Effektivwerte rein sinusförmiger Ströme mit der Grundfrequenz $f_1$ dar und rufen an den oberen Phasenklemmen des Schutzschalters die gleichen thermischen Wirkungen, d.h. die gleichen Übertemperaturen, wie die oberschwingungshaltigen Phasenströme $I_v$ hervor. In einem siebenten Verfahrensschritt g) wird aus den thermisch äquivalenten Phasenströmen $I_{TE,v}$ durch digitalen Vergleich deren größter Wert als maßgeblicher thermisch äquivalenter Strom $I_{TE}$ ermittelt. Damit ist ein Wert erfaßt worden, der im konkreten Fall für die im Klemmenraum auftretende höchste Übertemperatur verantwortlich ist. In einem abschließenden achten Verfahrensschritt h) wird digital aus dem thermisch äquivalenten Strom $I_{TE}$ unter Anwendung der Formel [1a] sowie der typbezogenen Konstanten **a**, **b**, **m** und **k** die maßgebliche Übertemperatur $\Delta\theta$ ermittelt. Die maßgebliche Übertemperatur $\Delta\theta$ ist die infolge der Phasenströme $I_v$ höchste - und damit zur Beurteilung der thermischen Oberschwingungsfestigkeit des Schutzschalters maßgebliche - der sich in den einzelnen oberen Phasenklemmen einstellenden Übertemperaturen.

Der Vergleich des ermittelten thermisch äquivalenten Stromes $I_{TE}$ mit dem vom Hersteller vorgegebenen maximal zulässigen Dauerstrom erlaubt bereits die Aussage darüber, ob der mit den erfaßten oberschwingungshaltigen Phasenströmen $I_v$ zu betreibende Schutzschalter bezüglich dieser Oberschwingungen bis zu der vom Hersteller vorgegebenen maximalen Umgebungstemperatur thermisch fest ist. Anderenfalls läßt sich der Minderungsfaktor (Derating) für den Nennstrom der zu schützenden Anlage aus dem Verhältnis des maximal zulässigen Dauerstromes des Schutzschalters zu dem bei vorgegebenem Stromverlauf ermittelten thermisch äquivalenten Strom $I_{TE}$ errechnen. Als Ergebnis des Verfahrens läßt sich auch die maximal zulässige Umgebungstemperatur für den vorgesehenen Einsatzfall ermitteln. Dazu ist unter Anwendung der Formel [1a] die bei Nennstrom auftretende Nennstromübertemperatur im Klemmenraum zu ermitteln, wobei in Formel [1a] $I_{TE}$ durch den Nennstrom zu ersetzen ist. Aus der Differenz der vom Hersteller angegebenen maximal möglichen Umgebungstemperatur und der nach dem Verfahren ermittelten und um die Nennstromübertemperatur verminderten maßgeblichen Übertemperatur $\Delta\theta$ ergibt sich die

für die konkreten Phasenströme $I_v$ zulässige Umgebungstemperatur. Aus den im dritten Verfahrensschritt c) erfaßten spektralen Teileffektivströmen $I_{i,eff,v}$ lassen sich nach bekannten Methoden die Grundschwingungsgehalte und die Klirrfaktoren der Phasenströme $I_v$ als Maß für die Abweichung der jeweiligen Kurvenform von einem rein sinusförmigen Verlauf ermitteln, um diese Werte für eine Beurteilung von Störungen, z.B. Sättigungseffekten, in der zu schützenden Anlage heranzuziehen.

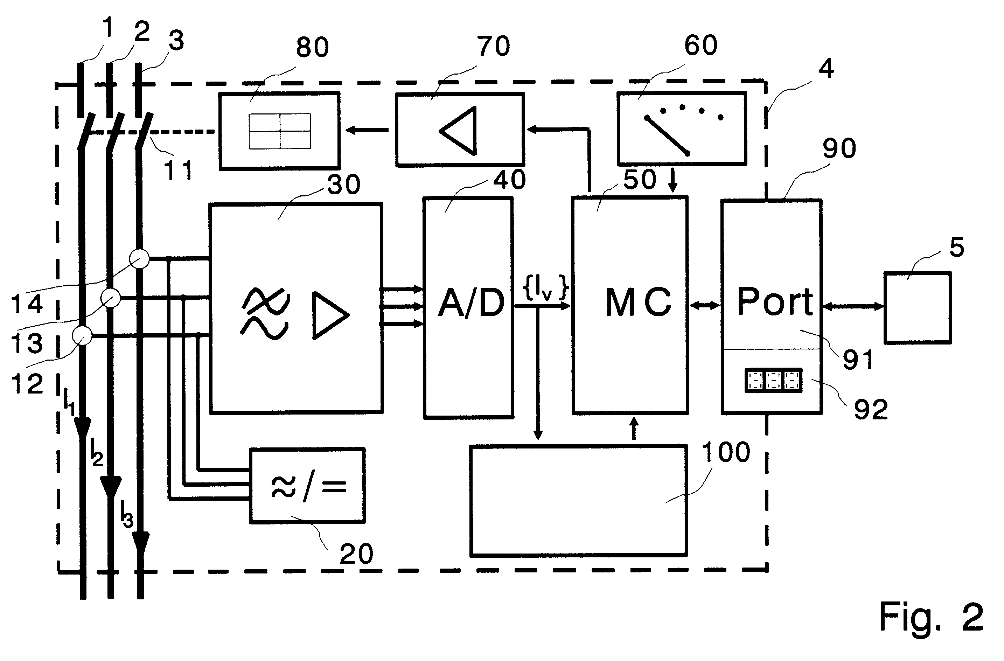

Fig. 2 stellt als Blockschaltbild die Auslöseelektronik, die damit verbundenen mechanischen und elektrischen Elemente sowie zusätzliche, für die Durchführung des Verfahrens erforderliche Mittel eines Schutzschalters, beispielsweise eines Leistungsschalters, dar. In den Phasenleitungen 1, 2 und 3 liegt der Schutzschalter 4 mit seinem dreipoligen Kontaktsystem 11. Über in den Phasenleitungen 1, 2 und 3 liegende, als Stromwandler ausgestaltete Stromsensoren 12, 13 und 14 wird eine Stromversorgungseinheit 20, die zur Bereitstellung von geeigneten Versorgungsspannungen für die Schaltungsanordnung dient, gespeist und gleichzeitig der in der jeweiligen Phasenleitung 1, 2 bzw. 3 fließende Phasenstrom $I_1$, $I_2$ bzw. $I_3$ sensorisch erfaßt. Die sensorisch erfaßten Phasenströme $I_1$, $I_2$ und $I_3$ werden Mitteln zur analogen Meßwertaufbereitung 30 zugeführt, das im wesentlichen ein Anti-Aliasing-Filter und einen Meßwertverstärker enthält. Die so aufbereiteten analogen Meßwertsignale gelangen zu einem A/D-Wandler 40, der mit einem eingangsseitigen analogen Multiplexer ausgestattet ist und mit einer festen Abtastfrequenz die erfaßten Stromwerte in eine zeit- und wertediskrete und damit digitale Signalfolge $\{I_v\}$ für jede Phase umgewandelt. Die digitalen Signalfolgen $\{I_v\}$ werden mittels eines Mikrokontrollers 50 weiterverarbeitet. Eine Einstelleinheit 60 enthält Einstellelemente für die einstellbaren Auslösewerte und liefert diese an den Mikrokontroller 50. Dieser gibt bei Über- bzw. Unterschreitung der Auslösewerte durch den jeweils fließenden Phasenstrom $I_1$, $I_2$ bzw. $I_3$ über einen Treiber 70 ein Auslösesignal an einen Kraftspeicher 80, um das Kontaktsystem 11 zu öffnen. Der Mikrokontroller 50 kommuniziert über eine Datenübermittlungseinheit 90 nach außen, in diesem Falle über seinen als Schnittstelle 91 ausgebildeten ersten Bestandteil mit einer externen, zentralen Steuerung 5 und über einen als Anzeige 92 ausgebildeten zweiten Bestandteil optisch mit dem Anwender. Eine mit dem Mikrokontroller 50 sowohl eingangs-als auch ausgangsseitig verbundene Erfassungseinheit 100 dient ausschließlich - allerdings im Zusammenwirken mit den Stromsensoren 12, 13 und 14, den Mitteln zur Meßwertaufbereitung 30, dem A/D-Wandler 40, dem Mikrokontroller 50, der Datenübermittlungseinheit 90, der Stromversorgungseinheit 20 sowie gegebenenfalls der zentralen Steuerung 5 und bzw. oder der Einstelleinheit 60 - der Ermittlung der thermischen Oberschwingungsfestigkeit des Schutzschalters 4.

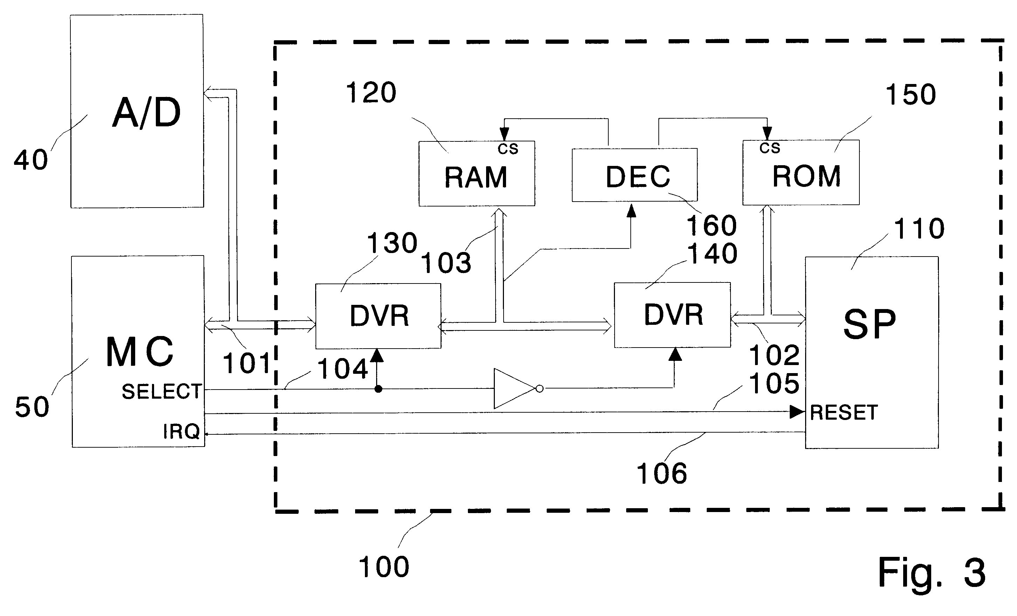

Die Erfassungseinheit 100 ist im einzelnen in Fig. 3 ausgeführt. Im allgemeinen ist der Mikrokontroller 50 mit der Bewältigung der Meßwertverarbeitung und der Schnittstellenarbeit ausgelastet. Daher erfordert die rechenintensive Durchführung der Verfahrensschritte c) bis h) eine eigene Intelligenz in Form eines nachgeordneten Signalprozessors 110. Dessen Festkomma-Arithmetik ist besonders für die Schnelle Fourier-Transformation und die Berechnung nichtlinearer Funktionen geeignet. Der Datenaustausch zwischen dem Mikrokontroller 50 als Hostprozessor und dem Signalprozessor 110 als Coprozessor erfolgt über einen Pufferspeicher 120 als externes Programm-RAM des Signalprozessors 110. Das Prozessorkonzept gängiger Signalprozessoren erlaubt trotz Harvard-Architektur, d.h. Trennung zwischen Programm- und Datenspeicher, den Transfer von Daten zwischen Programm- und Datenspeicher mittels der Befehle "table read" und "table write". Zur Übertragung der Daten ist somit der Zugriff des Mikrokontrollers 50 auf den Pufferspeicher 120 hinreichend. Der A/D-Wandler 40 und der Mikrokontroller 50 sind über einen ersten Systembus 101 mit einem ersten Bustreiber 130 verbunden. Der Signalprozessor 110 ist über einen zweiten Systembus 102 mit einem als ROM ausgeführten Befehlsspeicher 150 und einem zweiten Bustreiber 140 verbunden. Beide Bustreiber 130 und 140 sind über einen dritten Systembus 103 mit dem Pufferspeicher 120 und einem Dekoder 160, der zur selektierten Aktivierung des Pufferspeichers 120 und des Befehlsspeichers 150 dient, verbunden. In dem Befehlsspeicher 150 sind adressierbare Befehlsspeicherbereiche angelegt, welche die zur Durchführung der Verfahrensschritte c) bis h) erforderlichen Befehlsabläufe beinhalten.

Durch Aktivieren und Deaktivieren der Steuerleitungen, d.h. der Select-Leitung 104, der Reset-Leitung 105 und der Interrupt-Leitung 106, wird das Handshake-Protokoll zwischen dem Mikrokontroller 50 und dem Signalprozessor 110 gebildet. Indem der Mikrokontroller 50 die Select-Leitung 104 aktiviert, beschreibt er den Pufferspeicher mit den schutzschaltertypischen Parametern, mit einem Zeiger auf die vom Signalprozessor 110 auszuführende Routine entsprechend dem für den aktuellen Verfahrensschritt erforderlichen Speicherbereich im Befehlsspeicher 150 und mit dem Datensatz der vom A/D-Wandler 40 gelieferten digitalisierten Stromwerte. Die Deaktivierung der Select-Leitung 104 gibt den beschriebenen Pufferspeicher 120 für den Signalprozessor 110 frei. Die Abarbeitung des Programms des Signalprozessors 110 beginnt mit der Deaktivierung der Reset-Leitung 105 und endet damit, daß anschließend die Zwischen- oder Endergebnisdaten in den Pufferspeicher 120 geschrieben werden und der Mikrokontroller 50 durch die Aktivierung der Interrupt-Leitung 106 aufgefordert wird, die ermittelten Daten zu übernehmen.

5

Die Ausgabe des Endergebnisses erfolgt nach Fig. 2 über die Schnittstelle 91 zur Meldung oder zur Weiterverarbeitung an die zentrale Steuerung 5. Gleichzeitig wird das Endergebnis über die Anzeige 92 sichtbar ausgegeben. Es sei noch darauf hingewiesen, daß es in den Fällen, wo die Schaltungsanordnung zugehöriger Bestandteil des Schutzschalters ist, vielfach sinnvoll ist, die schutzschaltertypischen Parameter, insbesondere die typbezogenen Konstanten **a, b, m** und **k**, nicht in den Pufferspeicher 120 einzuschreiben, sondern mit in dem Befehlsspeicher 150 zu programmieren. Die Einstelleinheit 60 kann dahingehend gestaltet werden, daß auch die vorgenannten Parameter durch entsprechende, an sich bekannte Einstellmittel eingebbar sind. Eine Alternative dazu ist die Eingabe der vorzugebenden Parameter über die Schnittstelle 91 durch die zentrale Steuerung 5. Die letztgenannten beiden Möglichkeiten der Parametereingabe erlauben in universeller Weise die Verwendbarkeit der Schaltungsanordnung für verschiedene Schutzschaltertypen.

Vorausschauenderweise kann die thermische Oberschwingungsfestigkeit des Schutzschalters für zu erwartende Verläufe der Phasenströme auch in der Weise ermittelt werden, daß Daten, die die zu erwartenden Stromverläufe charakterisieren, über die Schnittstelle 91 eingegeben und verfahrensgemäß verarbeitet werden. Als charakterisierende Daten eignen sich hierzu vorzugsweise zeit- und wertediskrete Zahlenfolgen, die den zu erwartenden Stromverläufen entsprechen.

**Patentansprüche**

1. Verfahren zur Ermittlung der thermischen Festigkeit von Schutzschaltern unter Berücksichtigung der Oberwellen der Phasenströme, **gekennzeichnet durch** folgende mit analogen und mit rechnergestützten digitalen Meßmitteln durchgeführte Verfahrensschritte:

    a) Erfassung und analoge Meßwertaufbereitung der in den Phasenleitungen (1; 2; 3) fließenden Phasenströme ($I_v$), mit denen der zu prüfende Schutzschalter (4) beaufschlagt ist bzw. wird;

    b) Umwandlung der meßwertaufbereiteten Phasenströme ($I_v$) in zeit- und wertediskrete digitale Signalfolgen ($\{I_v\}$);

    c) Erfassung der spektralen Teileffektivströme ($I_{i,eff,v}$) der Phasenströme ($I_v$) aus den digitalen Signalfolgen ($\{I_v\}$) unter Anwendung der Schnellen Fourier-Transformation, wobei i ein ganzzahliges Vielfaches im Bereich von 1 bis n der Grundschwingung der Phasenströme ($I_v$) ist;

    d) Erfassung der von jedem spektralen Teileffektivstrom ($I_{i,eff,v}$) hervorgerufenen anteiligen Übertemperatur ($\Delta\theta_{i,v}$) an der betreffenden oberen Phasenklemme unter Anwendung der Formel

$$\Delta\theta_{i,v} = \frac{\dfrac{1}{I_{i,eff,v}^2} - b - \sqrt{(\dfrac{1}{I_{i,eff,v}^2} - b)^2 - 4\cdot a\cdot(m + k\cdot i\cdot f_1)}}{2\cdot a} \quad , \qquad [1]$$

$$i = 1, 2, \ldots, n \quad n = 20 \quad v = 1, 2, 3$$

wobei $f_1$ die Frequenz der Grundschwingung der Phasenströme ($I_v$) ist und die Konstanten **a, b, m** und **k** durch vorherige Meßreihen bestimmte, den jeweiligen Schutzschaltertyp kennzeichnende Parameter sind;

    e) Erfassung der den zugehörigen anteiligen Übertemperaturen ($\Delta\theta_{i,v}$) entsprechenden thermisch äquivalenten Teilströme ($I_{i,TE,v}$) der Grundfrequenz $f_1$ unter Anwendung der Formel

$$I_{i,TE,v} = \sqrt{\frac{\Delta\theta_{i,v}}{a\cdot\Delta\theta_{i,v}^2 + b\cdot\Delta\theta_{i,v} + m + k\cdot f_1}} \quad ; \qquad [2]$$

$$i = 1, 2, \ldots, n \quad n = 20 \quad v = 1, 2, 3$$

    f) Erfassung der thermisch äquivalenten Phasenströme ($I_{TE,v}$) aus den thermisch äquivalenten Teilströmen ($I_{i,TE,v}$) unter Anwendung der Formel

$$I_{TE,v} = \sqrt{\sum_{i=1}^{n} I_{i,TE,v}^2} \quad ; \qquad \qquad \qquad [3]$$

$$n = 20 \qquad v = 1, 2, 3$$

g) Erfassung des maßgeblichen thermisch äquivalenten Stromes ($I_{TE}$) aus dem größten der thermisch äquivalenten Phasenströmen ($I_{TE,v}$).

2.   Verfahren nach Anspruch 1, **gekennzeichnet durch** folgenden sich an den Verfahrensschritt g) anschließenden Verfahrensschritt:

h) Erfassung der maßgeblichen Übertemperatur ($\Delta\theta$) aus dem maßgeblichen thermisch äquivalenten Strom ($I_{TE}$) unter Anwendung der Formel

$$\Delta\vartheta = \frac{\dfrac{1}{I_{TE}^2} - b - \sqrt{(\dfrac{1}{I_{TE}^2} - b)^2 - 4 \cdot a \cdot (m + k \cdot f_1)}}{2 \cdot a} \qquad . \qquad [1a]$$

3.   Verfahren nach Anspruch 1 oder 2, **dadurch gekennzeichnet**, daß in den Verfahrensschritten c) bis f) die spektralen Teileffektivströme ($I_{i,eff,v}$), die anteiligen Übertemperaturen ($\Delta\theta_{i,v}$) und die thermisch äquivalenten Teilströme ($I_{i,TE,v}$) maximal bis zum Zwanzigfachen, d.h. n = 20, der Frequenz $f_1$ der Grundschwingung erfaßt werden.

4.   Verfahren nach einem der Ansprüche 1 bis 3, **dadurch gekennzeichnet**, daß der Verfahrensschritt c) durch eine sich unmittelbar anschließende Mittelwertbildung erweitert ist.

5.   Schaltungsanordnung zur Durchführung des Verfahrens nach einem der Ansprüche 1 bis 4, **gekennzeichnet durch**

- Stromsensoren (12; 13; 14) zur Erfassung der Phasenströme ($I_v$);
- Mittel zur Meßwertaufbereitung (30) der erfaßten Phasenströme ($I_v$);
- einen A/D-Wandler (40) mit eingangsseitigem Multiplexer zur Umwandlung der aufbereiteten Phasenströme ($I_v$) in zeit- und wertediskrete digitale Signalfolgen ($\{I_v\}$);
- einem Mikrokontroller (50) zur Organisation des internen und externen Datenaustausches sowie der internen Signalverarbeitung;
- eine mit dem Mikrokontroller (50) verbundene Datenübermittlungseinheit (90);
- einen dem Mikrokontroller (50) untergeordneten Signalprozessor (110) zur für die Durchführung der Verfahrensschritte erforderlichen Signal- und Datenverarbeitung;
- einen Pufferspeicher (120) zur Ablage der schutzschaltertypischen Parameter **a, b, k** und **m** sowie der Daten der digitalen Signalfolgen ($\{I_v\}$) durch den Mikrokontroller (50), zur Ablage der Daten der in den Verfahrensschritten c) bis g) bzw. c) bis h) erfaßten bzw. umgewandelten Größen durch den Signalprozessor (110), zur Bereitstellung dieser Parameter und Daten für den Signalprozessor (110) und zur Bereitstellung der Daten des erfaßten maßgeblichen thermisch äquivalenten Stromes ($I_{TE}$) bzw. der maßgeblichen Übertemperatur ($\Delta\theta$) für den Mikrokontroller (50);
- einem Befehlsspeicher (150), in dem vom Signalprozessor (110) adressierbare Befehlsspeicherbereiche zur Durchführung der Schnellen Fourier-Transformation sowie der in den Verfahrensschritten d) bis g) bzw. d) bis h) vorgesehenen Formelanwendungen vorhanden sind;
- eine busmäßige Verbindung zwischen dem A/D-Wandler (40), dem Mikrokontroller (50), der Datenübermittlungseinheit (90), dem Signalprozessor (110), dem Pufferspeicher (120) und dem Befehlsspeicher (150);
- einer Stromversorgungseinheit (20).

6.   Schaltungsanordnung nach Anspruch 5, **dadurch gekennzeichnet**,

- daß der A/D-Wandler (40), der Mikrokontroller (50) und ein erster Bustreiber (130) über einen ersten Systembus (101) verbunden sind;
- daß der Signalprozessor (110), der Befehlsspeicher (150) und ein zweiter Bustreiber (140) über einen zweiten Systembus (102) verbunden sind;
- daß der erste Bustreiber (130), der zweite Bustreiber (140) und der Pufferspeicher (120) über einen dritten Systembus (103) verbunden sind;
- daß der erste Bustreiber (130) und der zweite Bustreiber (140) abwechselnd vom Mikrokontroller (50) aktiviert werden.

7.  Schaltungsanordnung nach Anspruch 5 oder 6, **dadurch gekennzeichnet**, daß die Speicherbereiche des Befehlsspeichers (150) und/oder die Auswahl der im Pufferspeicher (120) abgelegten Parameter und Daten über einen Dekoder (160) vom Signalprozessor (110) adressierbar sind.

8.  Schaltungsanordnung nach einem der Ansprüche 5 bis 7, **dadurch gekennzeichnet**, daß der Befehlsspeicher (150) ein ROM ist.

9.  Schaltungsanordnung nach einem der Ansprüche 5 bis 8, **dadurch gekennzeichnet**, daß die Mittel zur Meßwertaufbereitung (30) im wesentlichen Verstärker und Anti-Aliasing-Filter sind.

10. Schaltungsanordnung nach einem der Ansprüche 5 bis 9, **dadurch gekennzeichnet**, daß die Stromversorgungseinheit (20) ihrerseits von den als Stromwandler ausgebildeten Stromsensoren (12; 13; 14) gespeist wird.

11. Schaltungsanordnung nach einem der Ansprüche 5 bis 10, **dadurch gekennzeichnet**, daß die Stromsensoren (12; 13; 14), die Mittel zur Meßwertaufbereitung (30), der A/D-Wandler (40), der Mikrokontroller (50), die Datenübermittlungseinheit (90) und die Stromversorgungseinheit (20) Bestandteil eines digitalen Überlastauslösers des zu prüfenden Schutzschalters (4) sind.

12. Schaltungsanordnung nach einem der Ansprüche 5 bis 10, **dadurch gekennzeichnet**,
- daß die Stromsensoren (12; 13; 14) als Stromzangen ausgebildet sind;
- daß die Schaltungsanordnung wesentlicher Bestandteil eines Prüfgerätes zum Prüfen der thermischen Festigkeit von Schutzschaltern ist.

13. Schaltungsanordnung nach einem der Ansprüche 5 bis 12, **dadurch gekennzeichnet**, daß die Datenübermittlungseinheit (90) eine Schnittstelle (91) zum externen Datenaustausch aufweist.

14. Schaltungsanordnung nach einem der Ansprüche 5 bis 13, **dadurch gekennzeichnet**, daß die Datenübermittlungseinheit (90) eine Anzeige (92) aufweist.

15. Schaltungsanordnung nach Anspruch 13 oder 14, **dadurch gekennzeichnet**, daß die Vorgabe der schutzschaltertypischen Parameter **a, b, k** und **m** durch dem Mikrokontroller (50) vorgeordnete, an sich bekannte Einstellmittel erfolgt.

Fig. 1a

$I_{1,TE,1}$
$I_{2,TE,1}$
$I_{i,TE,2}$ $I_{i,TE,3}$
$I_{20,TE,1}$

f

$$I_{TE,v} = \sqrt{\sum_{i=1}^{n} I_{i,TE,v}^{2}}$$

$n=20 \quad v=1, 2, 3 \quad [3]$

$I_{TE,1}$ $I_{TE,2}$ $I_{TE,3}$

g $\quad I_{TE} = \text{Max} \, ( \, I_{TE,v} \, )$

$v=1, 2, 3$

$I_{TE}$

h

$$\triangle \Theta = \frac{\dfrac{1}{I_{TE}^{2}} - b - \sqrt{\left(\dfrac{1}{I_{TE}^{2}} - b\right)^{2} - 4 \, a \, ( m + k \, f_{1} )}}{2 \, a}$$

$[ \, 1a \, ]$

$\triangle \Theta$

Fig. 1b

Fig. 2

Fig. 3

EP 0 609 662 A1

| | **EINSCHLÄGIGE DOKUMENTE** | | EP 94100228.9 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.⁵) |
| D,A | DE – A – 4 014 629 (ABB) * Zusammenfassung * -- | 1 | G 01 R 31/32 |
| D,A | DE – A – 3 731 543 (LICENTIA) * Zusammenfassung * -- | 1 | |
| A | DE – B – 2 043 731 (SIEMENS) * Anspruch 1 * ---- | 1 | |
| | | | **RECHERCHIERTE SACHGEBIETE (Int. Cl.⁵)** |
| | | | G 01 R 31/00 H 02 H 5/00 |

Der vorliegende Recherchenbericht wurde für alle Patentansprüche erstellt.

| Recherchenort | Abschlußdatum der Recherche | Prüfer |
|---|---|---|
| WIEN | 18-05-1994 | KUNZE |